# EUROPÄISCHE PATENTSCHRIFT

(11) **EP 1 575 344 B1**
(45) Veröffentlichungstag und Bekanntmachung des Hinweises auf die Patenterteilung: **30.05.2007**
(21) Anmeldenummer: 04005834.9
(22) Anmeldetag: 11.03.2004
(51) Int. Cl.: H05K 5/00, H05K 1/18

(54) **Steuergerät**
Control device
Dispositif de commande

(43) Veröffentlichungstag der Anmeldung: 14.09.2005
(73) Patentinhaber: SIEMENS AKTIENGESELLSCHAFT, 80333 München (DE)
(72) Erfinder: Bagung, Detlev, 93170 Bernhardswald (DE); Novotny, Klaus-Peter, 93073 Neutraubling (DE); Riepl, Dr. Thomas, 93049 Regensburg (DE)

(56) Entgegenhaltungen:
- EP-A- 0 706 311
- EP-A- 0 765 110
- US-A- 5 276 418
- US-A- 5 777 850
- US-B1- 6 288 343

## Beschreibung

Die Erfindung betrifft ein Steuergerät, insbesondere ein Steuergerät für ein Kraftfahrzeug, mit einem Gehäuse, in dem eine mehrlagige Leiterplatte untergebracht ist.

Es sind Bauformen eines Steuergeräts mit einem parallelen Steckerabgang bekannt, die jedoch aufgrund ihrer Bauform einen nicht unerheblichen Platzbedarf aufweisen. Bei einem parallelen Steckerabgang sind die Steckerteile an einer Stirnseite eines Gehäuses des Steuergeräts angeordnet, so dass die Fügerichtung des Steckverbinders parallel zu einer Bodenplatte des Gehäuses verläuft. Diese Bauform erweist sich aufgrund einer reduzierten Bauhöhe als vorteilhaft.

Zum einen ist es bekannt (DE 37 33 072 A1), Steckverbinder zu verwenden, bei denen die Steckerkontakte so gebogen sind, dass sie einerseits senkrecht auf der Leiterplattenebene stehen und aufgrund der Biegung der Kontaktstifte die Fügerichtung des Steckers parallel zu dieser Leiterplattenebene verläuft.

Weiter ist eine Leiterplatte mit mehreren starren Bereichen bekannt (US 5,77,850 A), die über flexible Leiterbahnenbereiche miteinander verbunden sind.

Weiter ist eine mehrlagige Leiterplatte bekannt (US 6,288,343 A), bei der ein erster mehrlagiger Leiterplattenbereich mit einem zweiten mehrlagigen Leiterplattenbereich über einen dritten Bereich verbunden ist, der im Vergleich zum ersten und zweiten Bereich eine geringere Anzahl von Lagen aufweist.

Bei dieser bekannten Bauform erweist es sich als nachteilig, dass der Bereich, in dem die Steckerkontakte zwischen Steckerteil und Leiterplatte verlaufen nicht mit elektrischen oder elektronischen Bauelementen bestückt werden kann und somit dieser Teil der Leiterplatte nicht genutzt werden kann.

Da der Bauraum, die ein Steuergerät beanspruchen darf immer kleiner wird, müssen die erforderlichen Bauelemente auf dem durch den Steckverbinder reduzierten Teil der Leiterplatte angeordnet werden. Hierdurch ergeben sich erhebliche Anforderungen an die Leiterplatte und an das Layout der Schaltungsanordnung.

Eine weitere bekannte Möglichkeit einen parallelen oder waagrechten Steckerabgang zu realisieren besteht darin, eine flexible Leiterplatte (sogenannte Flexfolie) auf feste Grundplatten meist Aluplatten zu laminieren und dabei einen Biegebereich zwischen der Leiterplatte und dem Steckverbinder auszulassen. Solche Aufbauten sind beispielsweise aus der DE 43 03 908 A1, der EP 0 706 311 B1 oder der US 6,655,017 B1 bekannt. Hierbei erweist es sich jedoch als nachteilig, dass flexible Leiterplattenfolien nur zweilagig erhältlich sind und zum anderen durch das Auflaminieren auf eine starre Platte nur einseitig bestückbar sind. Hierdurch erhöht sich der Grundflächenbedarf der Schaltungsanordnung wieder und weist keine Vorteile gegenüber einem Steckverbinder mit gebogenen Steckerkontakten auf.

Auch sind Flexfolien für Anwendungen mit modernen Mikrocontrollern nicht geeignet, da hier zumindest vier oder mehrlagige Leiterplatten erforderlich sind. Mit einer Flexfolie eignet sich weiter auch nicht, um Steckverbinder mit einer Vielzahl von Anschlussstiften zu kontaktieren. Die Anzahl der Anschlussstifte ist aufgrund ihres zweilagigen Aufbaus beschränkt.

Darüber hinaus kann ein Steckverbinder mit einer Flexfolie nur verlötet werden. Die Flexfolie ist nicht für eine Einpressen von Kontaktstiften geeignet. Wodurch auf eine zuverlässigere Kontaktierung mit Einpresskontakten verzichtet werden muss.

Ein weiterer Nachteil eines Steuergeräts, das mit flexiblen Leiterplattenfolien aufgebaut ist, ergibt sich dadurch, dass die Schaltungsanordnung aufgrund von fehlenden Schirmlagen im Hinblick auf die elektromagnetische Verträglichkeit (EMV) störanfällig ist.

Eine weitere bekannte Möglichkeit, eine mehrlagige Leiterplatte mit einem Steckverbinder zu verbinden, besteht darin, diese beiden wieder über ein gestecktes oder gelötetes Kabel zu verbinden (US 4,858,071A). Hierbei müssen jedoch die bei mehrlagigen Leiterplatten hauptsächlich in den Innenlagen verlaufenden logischen Signale in die Außenlagen der Leiterplatte geführt werden. Dieses so genannte Entflechten benötigt jedoch auch wieder Platz auf der Leiterplatte. Dieser ist meist größer als der Platzbedarf der abgewinkelten Steckerpins. Bei gesteckten Verbindungen benötigen die zusätzlichen Steckverbinder wiederum zusätzliche Fläche und Volumen im Steuergerät, sodass hier kein Bauraum gewonnen wird.

Ein Steckverbinder ist hier ein Bauelement, das es ermöglicht, elektrische Leiter anzuschließen, und dazu bestimmt ist, mit einem passenden Gegenstück Verbindungen herzustellen und/oder zu trennen. Steckverbinder sind Betriebsmittel, die ja bei bestimmungsgemäßer Verwendung (unter elektrischer Spannung) nicht gesteckt oder getrennt werden dürfen. Der Steckverbinder selbst besteht aus dem Steckverbindergehäuse und den Kontaktflächen oder Steckerkontakte. Bei dem Steckverbinder kann es sich hier jedoch auch um eine Steckvorrichtung handeln, d.h. ein Betriebsmittel, das bei bestimmungsgemäßer Verwendung unter elektrischer Spannung oder Last gesteckt oder getrennt werden darf.

Es ist Aufgabe der Erfindung, ein Steuergerät und ein Verfahren zum Herstellen eines Steuergeräts zu schaffen, das bei gleicher Grundfläche mehr Platz für elektrische und/oder elektronische Bauelemente bietet.

Die Aufgabe wird erfindungsgemäß durch ein Steuergerät mit den Merkmalen des Patentanspruchs 1 und durch ein Verfahren zum Herstellen eines Steuergeräts mit den Merkmalen des Patentanspruchs 6 gelöst.

Das Steuergerät weist ein Gehäuse, eine einstückige, mehrlagige Leiterplatte und einen Steckverbinder auf. Die Leiterplatte weist einen ersten mit elektrischen und/oder elektronischen Bauelementen bestückten Teil, einen zweiten mit dem Steckverbinder elektrisch und mechanisch verbundenen Teil und einen dritten, den ersten und den zweiten Teil der mehrlagigen Leiterplatte verbindenden Teil auf. Dieser dritte Teil stellt einen Biegebereich dar, der so ausgebildet ist, dass der zweite Teil der einstückigen Leiterplatte so gebogen werden kann, dass der Steckverbinder in einer so dafür vorgesehenen Ausnehmung des Gehäuses angeordnet werden kann. Der erste und zweite Teil der Leiterplatte weisen hierbei zumindest vier Lagen auf, der dritte Teil der Leiterplatte zwei Lagen.

Als Lage einer Leiterplatte ist hier eine auf ein Trägermaterial aufgebrachte metallische Kaschierung zu verstehen. Das Trägermaterial kann hierbei sowohl ein- als auch zweiseitig kaschiert sein. Eine Lage der Leiterplatte kann Leiterbahnen und/oder Masse- und Versorgungsflächen enthalten.

Dieser Aufbau bietet den Vorteil, dass eine mehrschichtige Leiterplatte über einen mehrschichtigen Biegebereich mit einem ebenfalls mehrschichtigen Anschlussbereich für einen Steckverbinder verbunden ist. Die Kontakte des Steckverbinders stehen hierbei senkrecht auf dem zweiten Teil der Leiterplatte. Durch diese Anordnung wird weiter der Anteil der Grundfläche der Leiterplatte erhöht, auf dem elektrische und/oder elektronische Bauelement angeordnet werden können.

Die Leiterplatte ist im dritten Teil der Leiterplatte flexibel oder biegbar. Flexibel bedeutet hier, dass die Leiterplatte nach dem Biegen ohne einen Anschlag in etwa in ihre Ausgangsform zurückkehrt. Biegbar bedeutet, dass die Leiterplatte zerstörungsfrei gebogen werden kann und nach dem Biegen weitestgehend in der Form verbleibt, in die sie gebogen wurde.

Vorteilhafte Weiterbildungen der Erfindung sind in den Unteransprüchen angegeben.

Deshalb sind im ersten Teil der Leiterplatte keine Leiterbahnen angeordnet, die zur direkten Verbindung zwischen Baueleementen und den Kontakten des Steckverbinders dienen. Die Verbindung zwischen elektrischen und/oder elektronischen Bauelementen und den Kontakten des Steckverbinders erfolgt über die Leiterbahnen des zweiten und dritten Teils der Leiterplatte.

Weiter kann der erste Teil der Leiterplatte beidseitig bestückt werden. Wodurch sich die mit elektrischen und/oder elektronischen Bauelementen bestückbare Bereich der Leiterplatte nahezu verdoppeln.

Vorteilhafte Weiterbildungen der Erfindung sind in den Unteransprüchen angegeben.

Bei der Leiterplatte handelt es sich vorzugsweise um eine starrflexible Leiterplatte. Diese weist zumindest im flexiblen Teil der Leiterplatte einen flexiblen, beispielsweise aus Polyimid, gefertigtes Trägermaterial (Kern) auf. Dieser Kern ist auf beiden Seiten mit jeweils einer metallischn Kaschierung versehen und im starren Bereich, hier dem ersten und dem zweiten Teil der Leiterplatte mit weiteren Lagen, bestehend aus starren Trägermaterialien (Basismaterial), beispielsweise Glasfaser und Epoxidharz (FR4) und ebenfalls einer metallischen Kaschierung versehen. Diese Lagen können jeweils durch eine Klebeschicht (Prepreq) verbunden sein.

Eine so aufgebaute Leiterplatte kann somit im flexiblen Teil, der aus Lagen mit einer flexiblen Zwischenschicht, einem Polyimidkern besteht so gebogen werden, dass die Kontaktelemente des Steckverbinders im gebogenen Zustand parallel zur Leiterplattenebene des ersten Teils der Leiterplatte verlaufen.

In einer zweiten bevorzugten Ausführungsform wird eine Leiterplatte, in dem Bereich, der als dritter Teil, somit als Biegebereich dienen soll, spanend bearbeitet, so dass die Anzahl der Lagen und auch die Leiterplattendicke in diesem Teil reduziert werden und ein zumindest einmal biegbarer Bereich, der dritte Teil der Leiterplatte, entsteht.

In einer dritten bevorzugten Ausführungsform kann die Leiterplatte aus einem sogenannten Semiflexmaterial gefertigt sein. Diese Semiflex-Leiterplatten lassen nur ein einmaliges Biegen zu und können dann nur noch statisch beansprucht werden. Das Basismaterial ist ein spezielles Harz und Polyimid, beispielsweise CEM1.

Es sind auch beliebige Kombinationen dieser zuvor genannten Ausführungsformen möglich.

Weiter kann die Leiterplatte einen zweiten Biegebereich aufweisen, der auf der dem ersten Biegebereich abgewandten Seite des zweiten Teils der Leiterplatte angeordnet ist und dem ein zum ersten Teil der Leiterplatte in einem gebogenen Zustand in etwa paralleler vierter Leiterplattenteil folgt. Durch diese in etwa "U"-förmige Anordnung der Leiterplatte wird der bestückbare Bereich des ersten und vierten Teils der Leiterplatte weiter erhöht. Hierbei werden dann die beiden starren ersten und vierten Teile der Leiterplatte über die flexiblen Bereiche der Leiterplatte und den ebenfalls starren am Steckverbinder angeordneten Teil der Leiterplatte verbunden. Hierdurch entsteht eine einfache platzsparende elektrische Verbindung zwischen dem ersten und dem vierten Teil der Leiterplatte.

Auf dem zweite Teil der Leiterplatte, der elektrisch und mechanisch mit dem Steckverbinder verbunden ist, können auch Bauelemente, insbesondere Abblockkondensatoren, die zur Verbesserung der elektromagnetischen Verträglichkeit und als Schutz gegen elektrostatische Entladungen dienen, angeordnet sein. Für diese Abblockkondensatoren ergibt sich hierdurch als Vorteil, dass diese Kondensatoren direkt am Steckkontakt, d.h. am Ort ihrer maximalen Wirkung angeordnet sind und auch im Bereich des ersten Teils der Leiterplatte keine Grundfläche benötigen.

In einer weiteren bevorzugten Ausführungsform handelt es sich bei den Kontakten des Steckverbinders um Einpresskontakte. Diese werden zur elektrischen und mechanischen Kontaktierung zwischen den Kontakten des Steckverbinders und der Leiterplatte in metallisierte Ausnehmungen des zweiten Teils der Leiterplatte eingepresst.

Hierbei kann prinzipiell zwischen zwei Ausführungsformen unterschieden werden. Zum einen den massiven Einpresskontakten, die im Einpressbereich massiv ausgebildet sind und bei denen die für die Einpressverbindungen notwendigen Kräfte durch die Verformung der Leiterplattenbohrung aufgebracht werden, in die der massive Einpresskontakt eingepresst wird. Zum anderen den elastische Kontaktelementen, die im Einpressbereich elastisch ausgebildet sind und bei denen die für die Einpressverbindung notwendigen Kräfte durch die Verformung des elastischen Einpresskontaktes aufgebracht werden.

Ein so ausgebildeter Steckverbinder mit Einpresskontakten kann somit nach dem Bestücken der Leiterplatte mit dieser elektrisch und mechanisch verbunden werden.
Somit kann die komplett bestückte Leiterplatte, auf der beispielsweise auch schon die Entkoppelkondensatoren aufgebracht sind zunächst in das Gehäuse eingesetzt werden, dieses Gehäuse anschließend verschlossen werden und im Anschluss daran der Steckverbinder von außen mit dem zweiten Teil der Leiterplatte verpresst werden.

Mehrere Ausführungsbeispiele der Erfindung sind nachfolgend unter Bezugnahme auf die schematischen Zeichnungen näher erläutert. Es zeigen:
- Figur 1: eine Explosionszeichnung eines erfindungsgemäßen Steuergeräts,
- Figur 2: eine Leiterplatte, wie sie in das Steuergerät gemäß Fig. 1 eingesetzt ist, und
- Figuren 3a, b und c: mehrere Ausführungsbeispiele der Leiterplatte für das Steuergerät.

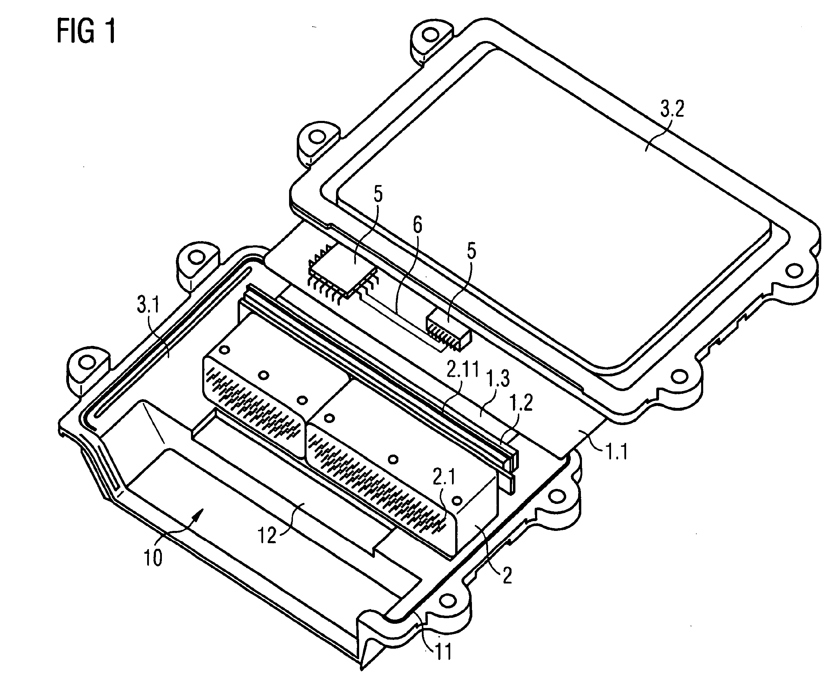

Figur 1 zeigt ein Steuergerät, beispielsweise ein Motor- oder Getriebesteuergerät für ein Kraftfahrzeug. Es sind auch kombinierte Steuergeräte für Motor und Getriebe oder sonstige Steuer- und Regelfunktionen eines Kraftfahrzeugs denkbar. Das Steuergerät weist ein Gehäuse 3 welches hier aus einem Gehäuseboden 3.1 und einem Gehäusedeckel 3.2 besteht auf. Das aus Boden 3.1 und Deckel 3.2 gebildete Gehäuse weist eine stirnseitige Öffnung 10 auf, in die ein Steckverbinder 2 eingesetzt werden kann. Der eingesetzte Steckverbinder schließt das Gehäuse ab.

Zwischen Boden 3.1 und Deckel 3.2 ist in einer Nut eine Dichtung 11 eingesetzt, hierbei kann es sich sowohl um eine aus einem Kunststoffmaterial vorgefertigte Dichtung, als auch um eine aushärtende oder nicht aushärtende Flüssigdichtung handeln. Zwischen Gehäuse 3 und dem Steckverbinder 2 ist ebenfalls eine Dichtung 2.11 eingesetzt.

Mit dem Steckverbinder 2 elektrisch und mechanisch verbunden ist eine Leiterplatte 1, die im montierten Zustand im Inneren des Gehäuses 3 angeordnet ist.

Diese mehrlagige Leiterplatte 1 weist einen ersten starren Teil 1.1 auf, der zumindest teilweise beidseitig mit Bauelementen 5 bestückt ist. Ein zweiter ebenfalls starrer Teil 1.2 der Leiterplatte ist elektrisch und mechanisch mit dem Steckverbinder 2 verbunden. Ein dritter Teil 1.3 ist zwischen dem ersten 1.1 und dem zweiten 1.2 Teil der Leiterplatte 1 angeordnet und verbindet diese elektrisch und mechanisch.

Dieser dritte Teil 1.3 ist biegbar, d. h. der zweite Teil 1.2 mit dem Steckverbinder 2 kann zumindest einmal zum Einbau der Leiterplatte 1 in das Gehäuse 3 in diesen Teil 1.3 gebogen werden, so dass der Steckverbinder 2 in die stirnseitige Öffnung 10 des Gehäuses eingesetzt werden kann.

Alternativ kann zunächst die gebogene Leiterplatte 1 in das Gehäuse 3 eingesetzt werden und der Steckverbinder 2 vor oder nach dem Schließen des Gehäuses, d. h. nach dem Montieren des Bodens 3.1 mit dem Deckel 3.2 in die Öffnung 10 eingesetzt werden. Hierbei ist es vorteilhaft, wenn die Kontaktstifte 2.1 des Steckverbinders 2 und die Ausnehmungen im zweiten Bereich 1.2 der Leiterplatte 1 so ausgebildet sind, dass die Kontaktstifte 2.1 einfach in die Ausnehmungen der Leiterplatte 1 eingepresst werden können und so eine elektrische und mechanische Verbindung zwischen Kontaktstift 2.1 und Leiterplatte 1.2 entsteht.

In Bereichen, in denen aufgrund hoher Verlustleistungen elektrischer Bauelemente 5 Wärme abgeführt werden muss, ist es vorteilhaft, die zweite Seite der Leiterplatte 1.1 direkt mit dem Boden 3.1 des Gehäuses 3 zu verbinden und so einen thermisch gut leitfähigen Pfad zum Abführen der durch die Verlustleistung erzeugten Wärme zu schaffen. Der Boden 3.1 wirkt somit als Kühlkörper.

In dem Bereich des ersten Teils 1.1 der Leiterplatte 1, in dem diese doppelseitig bestückt ist, weißt der Boden 3.2 eine Ausnehmung 12 auf. In diese Ausnehmung 12 ragen die auf der dem Boden 3.1 zugewandten Seite der Leiterplatte 1 bestückten Bauelemente in diese Ausnehmung 12. Der nur einseitig bestückte Bereich des ersten Teils 1.1 liegt plan auf dem Boden 3.1 auf, wodurch in diesem Bereich der thermische Obergangswiderstand zwischen Leiterplatte 1 und Boden 3.1 optimiert wird.

Die Leiterplatte 1 ist hier als vierlagige Leiterplatte ausgeführt. In Figur 1 sind jedoch nur schematisch zwei Leiterbahnen 6 der oberen Außenlage der Leiterplatte 1 dargestellt.

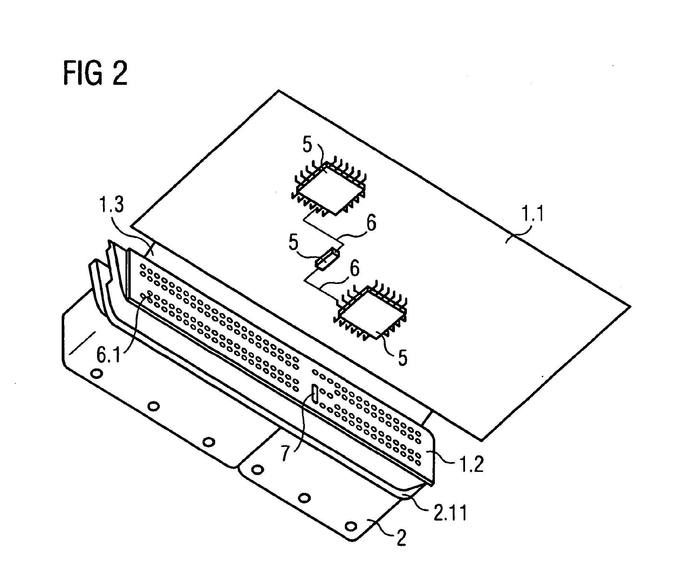

Figur 2 zeigt eine perspektivische Ansicht der mit dem Steckverbinder 2 verbundenen Leiterplatte 1. Dort ist die dem Boden 3.1 des Gehäuses 3 zugewandte Seite der Leiterplatte 1 dargestellt. Die Unterseite des ersten Teils 1.1 der Leiterplatte 1 weist wiederum elektrische Bauelemente 5 und zwei Leiterplatten 6 auf. Hierbei sind die Leiterbahnen 6 beispielhaft für alle Leiterbahnen, die auf der unteren Außenlage des ersten Teils 1.1 der Leiterplatte 1 angeordnet sind dargestellt.

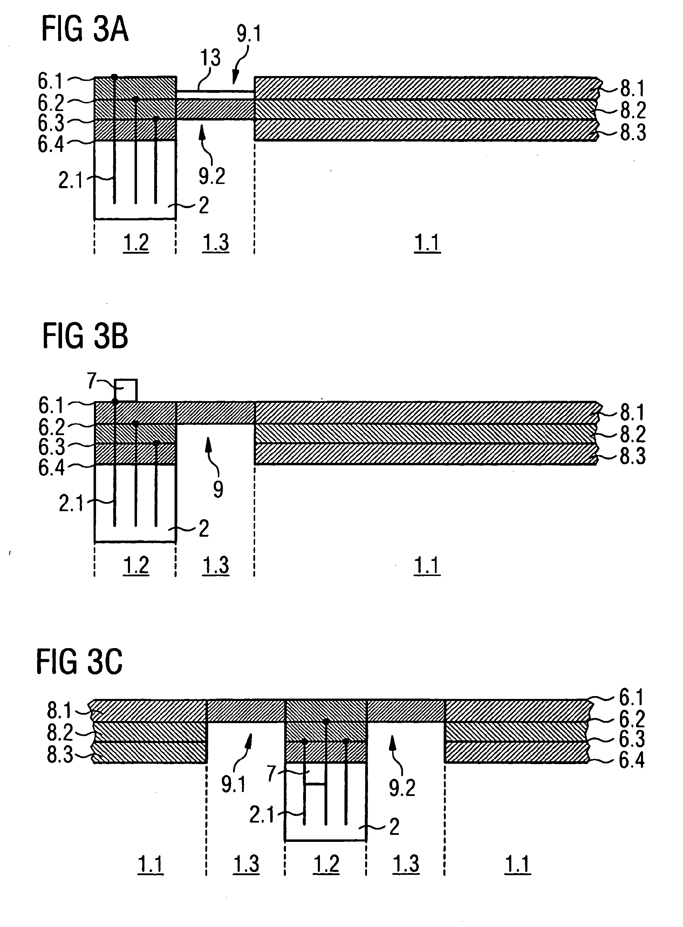

Auf der dem Steckverbinder 2 abgewandten Seite des zweiten Teils 1.2 der Leiterplatte 1 ist ein Kondensator 7 dargestellt (vgl. auch Fig. 3b), der einerseits mit einem ersten Kontaktstift 2.1 und andererseits mit einem zweiten Kontaktstift 2.1 oder mit Masse elektrisch verbunden ist und als so genannter Blockkondensator dient. Der Kondensator 7 erhöht die elektromagnetische Verträglichkeit (EMV) des Steuergeräts und schützt die elektrische Schaltung vor ungewollten elektrostatischen Entladungen (ESD).

Es erweist sich als besonders vorteilhaft diese Kondensatoren 7 möglichst nahe an den Kontaktstiften 2.1 anzuordnen, da sie dort nahe dem Ort der Entstehung der Störungen ihre maximale Wirkung entfalten. Es ist auch möglich Bauelemente, wie den Kondensator 7, auf der dem Steckverbinder 2 zugewandten Seite des zweiten Teils 1.2 zu befestigen (vgl. Fig.3c).

Die Figuren 3a, 3b und 3c stellen drei Ausführungsbeispiele von Leiterplatten 1 dar, wie sie in das Steuergerät eingesetzt werden können. Die Leiterplatten 1 sind hier im ungebogenen Zustand im Schnitt längs der Leiterplatte 1 dargestellt, dieser Zustand ermöglicht eine einfache Bestückung mit elektrischen und/oder elektronischen Bauelementen, da die ungebogene, ebene Leiterplatte einfach ohne zusätzlichen Aufwand in herkömmlichen Bestückungsautomaten bestückt werden kann.

Der Steckverbinder 2 mit seinen Kontaktstiften 2.1 und deren Kontaktierung mit den einzelnen Leiterbahnen 6 der Leiterplatte 1 ist hier der Einfachheit halber lediglich schematisch dargestellt. Die Punkte in den Figuren 3a, 3b und 3c stellen die elektrische Verbindung zur jeweiligen Leiterbahn 6.1, 6.2, 6.3 oder 6.4 dar.

Im Teil 1.1 weist die Leiterplatte 1 vier Lagen auf. Diese weisen jeweils eine metallisch Kaschierung, hier Leiterbahnen 6.1, 6.2, 6.3, und 6.4 auf. Zwischen diesen Leiterbahnen 6 sind drei Schichten Leiterplattenmaterial 8.1, 8.2 und 8.3 angeordnet. Bei dem Leiterplattenmaterial 8 handelt es sich insbesondere um faserverstärktes Epoxydharz (FR4). Zwischen Leiterplattenmaterial 8 und den Leiterbahnen 6 sind jeweils nicht dargestellte elektrisch isolierende Kleberschichten angeordnet. Dieser Aufbau gilt auch für den Teil 1.2 der Leiterplatte, in dem der Steckverbinder 2 angeordnet ist. Zwischen den Bereichen 1.1 und 1.2 ist der biegbare dritte Teil 1.3 angeordnet, der in der Figur 3a zwei Ausnehmungen 9.1 und 9.2 aufweist. Diese Ausnehmungen 9.1 und 9.2 können zum Einen bereits beim Fertigen ausgespart werden, so dass sich in diesem Teil 1..3 lediglich zwei Lagen Leiterbahnen 6.2 und 6.3 mit einem Kern 8.2 befinden. Hierbei ist darauf zu achten, dass das Material des Kerns - beispielsweise Polyimid - es zulässt, dass die Leiterplatte 1 im Teil 1.3 zumindest einmal gebogen werden kann. Zum Bestücken weist eine so aufgebaute Leiterplatte 1 im Teil 1.3 Streben 13 auf, die die Leiterplatte 1 dort bis zum eigentlichen Biegen verstärkt und so die Handhabung der Leiterplatte vereinfacht.

Alternativ können die Ausnehmungen 9.1 und 9.2 auch nach der Fertigung einer Leiterplatte 1, die zunächst vierlagig gefertigt ist, nachträglich spanend eingebracht werden, indem zwei Lagen wieder entfernt werden.

Figur 3b stellt ein weiteres Ausführungsbeispiel einer Leiterplatte 1 mit einem Steckverbinder 2 dar. Gleiche oder ähnliche Elemente wurden hier mit den gleichen Bezugszeichen wie im Ausführungsbeispiel gemäß Figur 3a versehen. Die Leiterplatte 1 in Figur 3b weist jedoch nur eine Ausnehmung 9 im Teil 1.3 auf, so dass im Teil 1.3 eine Außenlage 6.1 und eine Innenlage 6.2 den ersten Teil 1.1 und den zweiten Teil 1.2 der Leiterplatte 1 verbinden. Diese Ausnehmung 9 kann ebenfalls bei der Fertigung ausgespart werden oder nachträglich spanend entfernt werden. Die einseitige Ausnehmung 9 bringt verfahrenstechnische Vorteile mit sich, da die Leiterplatte 1 nur von einer Seite bearbeitet werden muss.

Figur 3c zeigt ein weiteres Ausführungsbeispiel einer Leiteplatte. Hier sind zwei doppelseitig bestückbare Teile 1.1 durch jeweils einen Biegebereich 1.3 mit einem einen Steckverbinder 2 tragenden Teil 1.2 der Leiterplatte 1 verbunden. Zum Einbau wird die Leiterplatte 1 in eine "U"-Form gebogen, so dass die Teile 1.1 in etwa übereinander liegen und die Kontaktstifte 2.1 in etwa parallel zu den Leiterbahnen 6 verlaufen. Der Teil 1.2 verbindet sowohl die auf den ersten Teilen 1.1 angeordneten Bauelemente mit den Kontaktstiften 2.1. Sie dient zusätzlich auch noch zur Verbindung der beiden ersten Teile 1.1 der Leiterplatte 1. Die Ausnehmungen 9.1 und 9.2 sind hier wie in Figur 3b beschrieben ausgeführt, können jedoch auch gemäß des in Figur 3a beschriebenen Ausführungsbeispiels ausgeführt sein.

Bei dem Ausführungsbeispiel gemäß Figur 3c kann durch einen mehrlagigen Teil 1.2 sowohl ein drei oder mehrreihiger Steckverbinder, als auch eine elektrische Verbindung der Teile 1.1 der Leiterplatte 1 realisiert werden.

Da die Verbindung der Teile 1.1 und 1.2 sowohl durch Außenals auch Innenlagen 6 der Leiterplatte 1 erfolgen kann reduziert sich der Platzbedarf zur Entflechtung der Leiterbahnen, wie er beispielsweise nötig wäre, wenn eine starre Leiterbahn durch eine mittels eines Lot oder anderen Kontaktierungsweisen angeordnete flexible Leiterbahn verbunden werden würde.

Werden die Ausnehmungen 9 mittels eines spanenden Verfahrens hergestellt, so kann die Leiterplatte 1 zunächst herkömmlich bestückt werden, da sie zu diesem Zeitpunkt noch keinen flexiblen oder biegbaren Teil aufweist. Die Ausnehmungen 9 entstehen dann in einem Arbeitsschritt nach dem Bestücken indem beispielsweise eine einseitige Ausnehmung 9 oder eine beidseitige Ausnehmung 9.1 und 9.2 wie in Figur 3a dargestellt in die Leiterplatte 3a eingefräst wird.

Die Anordnung eines Bauelements, hier eines Kondensators 7, auf dem zweiten Teil 1.2 der Leiterplatte 1 ist in den Figuren 3b und 3c ebenfalls schematisch dargestellt.

## Patentansprüche

1. Steuergerät, insbesondere für ein Kraftfahrzeug, das aufweist:
- ein Gehäuse (3),
- eine einstückige mehrlagige Leiterplatte (1), wobei eine Lage wenigstens eine auf ein Trägermaterial aufgebrachte metallische Kaschierung aufweist und
- wobei die Leiterplatte einen ersten mit elektrischen und/oder elektronischen Bauelementen (5) bestückten Teil (1.1) aufweist, wobei dieser erste Teil (1.1) zumindest vier Lagen (6, 8) aufweist,
- wobei die Leiterplatte (1) einen zweiten Teil (1.2) aufweist, der ebenfalls zumindest vier Lagen (6, 8) aufweist und mit einem Kontaktstift (2.1) eines Steckverbinder (2) elektrisch und mechanisch verbunden ist,
- wobei die Leiterplatte (1) einen dritten Teil (1.3) aufweist, der den ersten (1.1.) und den zweiten (1.2) Teil der Leiterplatte (1) verbindet und zumindest zwei Lagen (6, 8) aufweist, wobei die Leiterplatte (1) in diesem dritten Teil (1.3) flexibel oder zumindest biegbar ist, und
- wobei die Kontaktstifte (2.1) des Steckverbinders (2) mit den Leiterbahnen (6) des zweiten Teils (1.2) der Leiterplatte (1) durch eine Einpressverbindung verbunden sind.

2. Steuergerät nach Anspruch 1, **dadurch gekennzeichnet, dass** auf dem zweiten Teil (1.2) Bauelemente (7) angeordnet sind, die elektrisch mit einem Kontaktstift (2.1) und/ oder einer Leiterbahn (6) des zweiten Teils (1.2) verbunden sind.

3. Steuergerät nach einem der Ansprüche 1 oder 2, **dadurch gekennzeichnet, dass** der erste Teil (1.1) der Leiterplatte (1) zumindest teilweise beidseitig mit elektrischen und/ oder elektronischen Bauelementen (5) bestückt ist.

4. Steuergerät nach einem der Ansprüche 1 bis 3, **dadurch gekennzeichnet, dass** zumindest zwei Kontaktstifte (2.1) des Steckverbinders (2) durch eine Leiterbahn (6.1) des zweiten Teils (1.2) der Leiterplatte (1) elektrisch verbunden sind.

5. Verfahren zum Herstellen eines Steuergeräts, dass die folgenden Schritte aufweist:
- Bestücken eines ersten Teils (1.1) einer einstückigen mehrlagigen Leiterplatte (1) mit elektrischen und/oder elektronischen Bauelementen (5), wobei der erste Teil (1.1) zumindest vier Lagen aufweist und eine Lage wenigstens eine auf ein Trägermaterial aufgebrachte metallische Kaschierung aufweist,
- Einsetzen der Leiterplatte (1) in einen Boden (3.1) eines Gehäuses (3), wobei ein zweiter Teil (1.2) der Leiterplatte (1), der zumindest vier Lagen aufweist, durch Biegen vor oder bei dem Einsetzen in das Gehäuse (3) in einem dritten Teil (1.3) der Leiterplatte (1), der zumindest zwei Lagen aufweist, so abgewinkelt wird, dass die Ebenen des ersten (1.1) und des zweiten (1.2) Teils der Leiterplatte (1) mit einem Winkel kleiner 180 Grad, insbesondere einem Winkel von etwa 90 Grad angeordnet sind,
- Befestigen eines Steckverbinders am zweiten Teil (1.2) der Leiterplatte (1), und
- Verschließen des Gehäuses (3) mit einem Deckel (3.2),
wobei die elektrische Verbindung zwischen einem Kontaktstift (2.1) und den Leiterbahnen (6) des zweiten Teils (1.2) der Leiterplatte (1) durch Einpressen hergestellt wird.

6. Verfahren zum Herstellen eines Steuergeräts nach Anspruch 5, **dadurch gekennzeichnet, dass** vor dem Befestigen des Steckverbinders (2) auf dem zweiten Teil (1.2) der Leiterplatte (1) elektronische und/ oder elektrische Bauelemente (7) befestigt werden.

## Claims

1. Control device, in particular for a motor vehicle, having:
- a housing (3),
- a single-piece multilayer printed board (1), one layer having at least one metallic coating applied to a support material and
- the printed board having a first part (1.1) fitted with electrical and/or electronic components (5), said first part (1.1) having at least four layers (6, 8),
- the printed board (1) having a second part (1.2), which similarly has at least four layers (6, 8) and is connected electrically and mechanically to a contact pin (2.1) of a connector (2),
- the printed board (1) having a third part (1.3), which connects the first (1.1) and second (1.2) parts of the printed board (1) and has at least two layers (6, 8), the printed board (1) being flexible or at least bendable in this third part (1.3) and
- the contact pins (2.1) of the connector (2) being connected to the printed conductors (6) of the second part (1.2) of the printed board (1) by means of a press-in connection.

2. Control device according to claim 1,
**characterised in that** components (7) are disposed on the second part (1.2), said components (7) being connected electrically to a contact pin (2.1) and/or a printed conductor (6) of the second part (1.2).

3. Control device according to one of claims 1 or 2,
**characterised in that** the first part (1.1) of the printed board (1) is fitted at least partially on both sides with electrical and/or electronic components (5).

4. Control device according to one of claims 1 to 3,
**characterised in that** at least two contact pins (2.1) of the connector (2) are connected electrically by a printed conductor (6.1) of the second part (1.2) of the printed board (1).

5. Method for producing a control device, having the following steps:
- fitting a first part (1.1) of a single-piece multilayer printed board (1) with electrical and/or electronic components (5), the first part (1.1) having at least four layers and one layer having at least one metallic coating applied to a support material,
- inserting the printed board (1) into a base (3.1) of a housing (3), a second part (1.2) of the printed board (1), which has at least four layers, being angled, by bending in front of or insertion into the housing (3) in a third part (1.3) of the printed board (1), which has at least two layers, in such a manner that the planes of the first (1.1) and second (1.2) parts of the printed board (1) are disposed at an angle less than 180 degrees, in particular an angle of around 90 degrees,
- fixing a connector to the second part (1.2) of the printed board (1) and
- closing the housing (3) with a cover (3.2), the electrical connection between a contact pin (2.1) and the printed conductors (6) of the second part (1.2) of the printed board (1) being produced by pressing in.

6. Method for producing a control device according to claim 5, **characterised in that** electronic and/or electrical components (7) are fixed before the connector (2) is fixed to the second part (1.2) of the printed board (1)

## Revendications

1. Appareil de commande, en particulier pour un véhicule à moteur, comprenant :
- un boîtier (3),
- une plaquette de circuits imprimés monobloc multicouche (1), au moins une couche comportant un laminage métallique appliqué sur un matériau support,
- la plaquette de circuits imprimés comprenant une première partie (1.1) sur laquelle sont montés des composants électriques et/ou électroniques (5), cette première partie (1.1) contenant au moins quatre couches (6, 8),
- la plaquette de circuits imprimés (1) comprenant une deuxième partie (1.2) qui contient également au moins quatre couches (6, 8) et qui est connectée électriquement et mécaniquement avec une broche de contact (2.1) d'un connecteur à fiches (2),
- la plaquette de circuits imprimés (1) comprenant une troisième partie (1.3) qui relie la première partie (1.1) et la deuxième partie (1.2) de la plaquette de circuits imprimés (1) l'une à l'autre et qui contient au moins deux couches (6, 8), cette troisième partie (1.3) de la plaquette de circuits imprimés (1) étant flexible ou au moins pliable,
- les broches de contact (2.1) du connecteur à fiches (2) étant reliées aux pistes conductrices (6) de la deuxième partie (1.2) de la plaquette de circuits imprimés (1) par un raccord à enfoncement.

2. Appareil de commande selon la revendication 1, **caractérisé en ce que** la deuxième partie (1.2) porte des composants (7) qui sont connectés à une broche de contact (2.1) et/ou à une piste conductrice (6) de la deuxième partie (1.2).

3. Appareil de commande selon l'une des revendications 1 et 2, **caractérisé en ce que** la première partie (1.1) de la plaquette de circuits imprimés (1) est équipée au moins partiellement sur les deux faces de composants (5) électriques et/ou électroniques.

4. Appareil de commande selon l'une des revendications 1 à 3, **caractérisé en ce qu'**au moins deux broches de contact (2.1) du connecteur à fiches (2) sont connectées électriquement l'une à l'autre via une piste conductrice (6.1) de la deuxième partie (1.2) de la plaquette de circuits imprimés (1).

5. Procédé pour la fabrication d'un appareil de commande, comprenant les étapes suivantes :
- le montage de composants électriques et/ou électroniques (5) sur une première partie (1.1) d'une plaquette de circuits imprimés monobloc multicouche (1), cette première partie (1.1) comprenant au moins quatre couches, une des couches comportant au moins un laminage métallique appliqué sur un matériau support,
- l'insertion de la plaquette de circuits imprimés (1) dans le fond (3.1) d'un boîtier (3), une deuxième partie (1.2) de la plaquette de circuits imprimés (1) qui comporte au moins quatre couches étant pliée, avant ou pendant l'insertion dans le boîtier (3) en une troisième partie (1.3) de la plaquette de circuits imprimés (1) qui contient au moins deux couches, de telle sorte que les plans de la première partie (1.1) et de la deuxième partie (1.2) de la plaquette de circuits imprimés (1) forment entre eux un angle inférieur de 180°, en particulier un angle d'environ 90°,
- la fixation d'un connecteur à fiches sur la deuxième partie (1.2) de la plaquette de circuits imprimés (1), et
- la fermeture du boîtier (3) par un couvercle (3,2),
la connexion électrique entre une broche de contact (2.1) et les pistes conductrices (6) de la deuxième partie (1.2) de la plaquette de circuits imprimés (1) étant effectuée par enfoncement.

6. Procédé pour la fabrication d'un appareil de commande selon la revendication 5, **caractérisé en ce que** des composants électroniques et/ou électriques (7) sont montés avant la fixation du connecteur à fiches (2) sur la deuxième partie (1.2) de la plaquette de circuits imprimés (1).
